# EUROPEAN PATENT APPLICATION

(11) **EP 4 618 704 A1**
(43) Date of publication of application: **17.09.2025**
(21) Application number: 23887926.6
(22) Date of filing: 03.11.2023
(51) Int. Cl.: H05K 7/20

(54) **IN-VEHICLE HEAT-PIPE HEAT DISSIPATION CONTROLLER, AND VEHICLE**

(30) Priority: 11.11.2022 CN 202223015024 U
(71) Applicant: Nio Technology (Anhui) Co., Ltd, Hefei City, Anhui 230601 (CN)
(72) Inventor: ZHOU, Wei, Shanghai 201804 (CN); SHI, Jiepei, Shanghai 201804 (CN); LIU, Shuaijie, Shanghai 201804 (CN); WANG, Fei, Shanghai 201804 (CN); CENG, Yong, Shanghai 201804 (CN)
(74) Representative: Vossius & Partner Patentanwälte Rechtsanwälte mbB
(86) International application number: PCT/CN2023/129730
(87) International publication number: WO 2024/099236

(57) **Abstract**

Provided are an in-vehicle heat-pipe heat dissipation controller and a vehicle, which relate to the technical field of controllers, and aim to solve the problem of an increase in maintenance costs caused by a short circuit of a circuit board and reduction in efficiency of heat dissipation pipes due to the fact that the surface of the existing heat-pipe heat dissipation controller is corroded. The in-vehicle heat-pipe heat dissipation controller comprises a heat dissipation aluminum substrate (1), a heat dissipation aluminum block (2), a first heat pipe (3) and a second heat pipe (4); the first heat pipe (3) and the second heat pipe (4) are arranged on the heat dissipation aluminum substrate (1), and the heat dissipation aluminum block (2) is secured onto the heat dissipation aluminum substrate (1) and arranged above one end of the first heat pipe (3) as well as one end of the second heat pipe (4); and the surface of the heat dissipation aluminum substrate (1), the surface of the heat dissipation aluminum block (2), the surface of the first heat pipe (3) and the surface of the second heat pipe (4) are each plated with a corrosion-resistant material layer for oxidation resistance. By plating the corrosion-resistant material layer, the surface of the heat dissipation aluminum substrate (1), the surface of the heat dissipation aluminum block (2), the surface of the first heat pipe (3), and the surface of the second heat pipe (4) can be prevented from being corroded, such that the short circuit of the circuit board and the reduction in efficiency of the heat pipes are avoided, thereby lowering the maintenance costs and effectively improving the user experience.

## Description

### Cross Reference to Related Application

This application claims the priority to Chinese Patent Application No. CN 202223015024.3, filed on November 11, 2022, and entitled "IN-VEHICLE HEAT-PIPE HEAT DISSIPATION CONTROLLER, AND VEHICLE", which is incorporated herein by reference in its entirety.

### Technical Field

The invention relates to the technical field of controllers, and in particular to an in-vehicle heat-pipe heat dissipation controller and a vehicle.

### Background Art

A heat dissipation aluminum substrate, a heat dissipation aluminum block and heat dissipation pipes in a heat-pipe heat dissipation controller have various structures. For example, since it is difficult to cover a groove formed in the heat dissipation aluminum substrate with a covering film, the heat dissipation aluminum substrate plated with a common nickel layer will be corroded in a salt spray test, leading to peeling and flaking, which in turn causes a short circuit of a circuit board. The heat dissipation pipe is made of copper and may be soldered without nickel plating. In the high temperature and high humidity test for the heat dissipation pipe, the surface of the heat dissipation pipe may be oxidized, resulting in the short circuit and the reduced efficiency, thus increasing maintenance costs and bringing users poor experience.

Accordingly, there is a need for a new in-vehicle heat-pipe heat dissipation controller in the art to solve the above problem.

### Summary

The invention is intended to solve the above technical problem, i.e., to solve the problem of an increase in maintenance costs caused by a short circuit of a circuit board and reduction in efficiency of heat dissipation pipes due to the fact that the surface of the existing heat-pipe heat dissipation controller is corroded.

In a first aspect, the invention provides an in-vehicle heat-pipe heat dissipation controller comprising a heat dissipation aluminum substrate, a heat dissipation aluminum block, a first heat pipe and a second heat pipe; wherein the first heat pipe and the second heat pipe are arranged on the heat dissipation aluminum substrate, and the heat dissipation aluminum block is secured onto the heat dissipation aluminum substrate and arranged above one end of the first heat pipe as well as one end of the second heat pipe; and the surface of the heat dissipation aluminum substrate, the surface of the heat dissipation aluminum block, the surface of the first heat pipe and the surface of the second heat pipe are each plated with a corrosion-resistant material layer for oxidation resistance.

In a preferred technical solution of the in-vehicle heat-pipe heat dissipation controller described above, the corrosion-resistant material layer is made of nickel aminosulfonate.

In a preferred technical solution of the in-vehicle heat-pipe heat dissipation controller described above, the first heat pipe and the second heat pipe are both U-shaped pipes, the two U-shaped pipes are arranged on the heat dissipation aluminum substrate in the form of two ends protruding opposite each other, and the ends of the two U-shaped pipes under the heat dissipation aluminum block abut against each other.

In a preferred technical solution of the in-vehicle heat-pipe heat dissipation controller described above, a third recess is formed in the bottom of the heat dissipation aluminum block and configured for embedding the ends of the first heat pipe and the second heat pipe that abut against each other.

In a preferred technical solution of the in-vehicle heat-pipe heat dissipation controller described above, a hollow structure is formed in the middle of the heat dissipation aluminum substrate, the end of the first heat pipe and the end of the second heat pipe that abut against each other are both located in the hollow structure, and the heat dissipation aluminum block is secured to the hollow structure.

In a preferred technical solution of the in-vehicle heat-pipe heat dissipation controller described above, lugs are symmetrically arranged at two sides of the bottom of the heat dissipation aluminum block, first mounting grooves are symmetrically provided at two sides of the hollow structure, and the lugs abut in the first mounting grooves respectively such that the heat dissipation aluminum block is restricted.

In a preferred technical solution of the in-vehicle heat-pipe heat dissipation controller described above, the hollow structure comprises a first opening and a second opening that are symmetrically provided; and the first opening is configured for the insertion of the second heat pipe and turns on one side of the upper portion of the heat dissipation aluminum substrate, the second opening is configured for the insertion of the first heat pipe and turns on the other side of the upper portion of the heat dissipation aluminum substrate, and the second heat pipe and the first heat pipe turn in opposite directions such that the first heat pipe and the second heat pipe are in the form of two ends protruding opposite each other.

In a preferred technical solution of the in-vehicle heat-pipe heat dissipation controller described above, a first recess and a second recess are symmetrically formed in the upper portion of the heat dissipation aluminum substrate; the first recess is configured for the embedding of the first heat pipe; and the second recess is configured for the embedding of the second heat pipe; wherein the first recess and the second opening are connected in a through manner, and the second recess and the first opening are connected in a through manner, so that the end of the first heat pipe and the end of the second heat pipe that abut against each other are both located in the hollow structure.

In a preferred technical solution of the in-vehicle heat-pipe heat dissipation controller described above, the controller further comprises a plurality of elastic members, and the plurality of elastic members are mounted at equal intervals under the heat dissipation aluminum block such that the heat dissipation aluminum block is in a horizontal state; wherein a plurality of second mounting grooves are symmetrically formed in the bottom of the heat dissipation aluminum block, the plurality of second mounting grooves are provided in one-to-one correspondence with the plurality of elastic members, and upper ends of the elastic members are inserted in the second mounting grooves, respectively.

In the case of using the above technical solution, the in-vehicle heat-pipe heat dissipation controller of the invention comprises a heat dissipation aluminum substrate, a heat dissipation aluminum block, a first heat pipe and a second heat pipe; the first heat pipe and the second heat pipe are arranged on the heat dissipation aluminum substrate, and the heat dissipation aluminum block is secured onto the heat dissipation aluminum substrate and arranged above one end of the first heat pipe as well as one end of the second heat pipe and abut on the ends; and the surface of the heat dissipation aluminum substrate, the surface of the heat dissipation aluminum block, the surface of the first heat pipe and the surface of the second heat pipe are each plated with a corrosion-resistant material layer for oxidation resistance. According to the invention, by plating the corrosion-resistant material layer, the surface of the heat dissipation aluminum substrate, the surface of the heat dissipation aluminum block, the surface of the first heat pipe, and the surface of the second heat pipe can be prevented from being corroded, thereby avoiding the short circuit of the circuit board and the reduction in efficiency of the heat pipes, lowering the maintenance costs, and effectively improving the user experience.

In a second aspect, the invention provides a vehicle, comprising an in-vehicle heat-pipe heat dissipation controller as described in the first aspect.

The vehicle of the technical solution comprises an in-vehicle heat-pipe heat dissipation controller as in any technical solution of the invention, and thus the vehicle has all the technical effects of the in-vehicle heat-pipe heat dissipation controller as in any technical solution of the invention.

### Brief Description of the Drawings

Preferred implementations of the invention are described below with reference to the accompanying drawings, in which:
FIG. 1 is a structural diagram of an in-vehicle heat-pipe heat dissipation controller of the invention;
FIG. 2 is an exploded view of parts of an in-vehicle heat-pipe heat dissipation controller of the invention; and
FIG. 3 is a bottom view of an in-vehicle heat-pipe heat dissipation controller of the invention.

### List of reference signs:

1. heat dissipation aluminum substrate; 11. hollow structure; 12. first mounting groove; 13. first opening; 14. second opening; 15. first recess; 16. second recess; 2. heat dissipation aluminum block; 21. third recess; 22. second mounting groove; 23. lug; 3. first heat pipe; 31. first port; 32. third port; 33. front portion of the first heat pipe; 34. middle portion of the first heat pipe; 35. rear portion of the first heat pipe; 4. second heat pipe; 41. second port; 42. fourth port; 43. front portion of the second heat pipe; 44. middle portion of the second heat pipe; 45. rear portion of the second heat pipe; 5. elastic member.

### Detailed Description of Embodiments

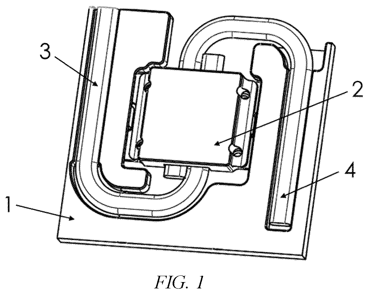

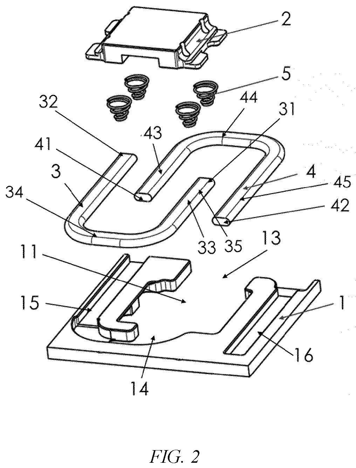

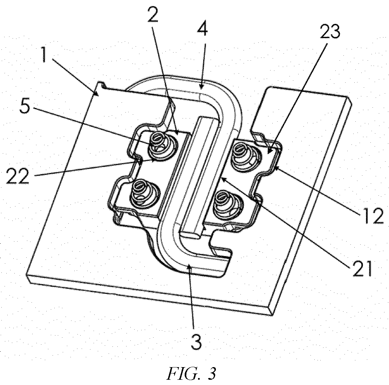

FIG. 1 is a structural diagram of an in-vehicle heat-pipe heat dissipation controller of the invention. FIG. 2 is an exploded view of parts of an in-vehicle heat-pipe heat dissipation controller of the invention. FIG. 3 is a bottom view of an in-vehicle heat-pipe heat dissipation controller of the invention. As shown in FIGS. 1 to 3, an in-vehicle heat-pipe heat dissipation controller of the invention typically comprises a heat dissipation aluminum substrate 1, a heat dissipation aluminum block 2, a first heat pipe 3 and a second heat pipe 4. The first heat pipe 3 and the second heat pipe 4 are arranged on the heat dissipation aluminum substrate 1, the heat dissipation aluminum block 2 is secured onto the heat dissipation aluminum substrate 1, and the heat dissipation aluminum block 2 is arranged above one end of the first heat pipe 3 as well as one end of the second heat pipe 4. The surface of the heat dissipation aluminum substrate 1, the surface of the heat dissipation aluminum block 2, the surface of the first heat pipe 3 and the surface of the second heat pipe 4 are each plated with a corrosion-resistant material layer for oxidation resistance. By plating the surface of the heat dissipation aluminum substrate 1, the surface of the heat dissipation aluminum block 2, the surface of the first heat pipe 3, and the surface of the second heat pipe 4 with the corrosion-resistant material layer for oxidation resistance, the surface of the heat dissipation aluminum substrate 1, the surface of the heat dissipation aluminum block 2, the surface of the first heat pipe 3, and the surface of the second heat pipe 4 can be prevented from being corroded, thereby avoiding a short circuit of a circuit board and reduction in efficiency of the heat pipes, lowering maintenance costs, and effectively improving the user experience.

In this embodiment, the heat dissipation aluminum substrate 1, the heat dissipation aluminum block 2, the first heat pipe 3 and the second heat pipe 4 are connected in a soldering manner such that the heat dissipation aluminum substrate 1, the heat dissipation aluminum block 2, the first heat pipe 3 and the second heat pipe 4 are integrated into a whole.

The corrosion-resistant material layer is made of nickel aminosulfonate. The corrosion-resistant material layer may also be made of other corrosion-resistant materials and is not limited to nickel aminosulfonate.

In this embodiment, the corrosion-resistant material layer may be one layer or two or three layers, which may be set by those skilled in the art according to the actual situation.

It should be noted that the invention does not impose specific limitations on the thickness of the corrosion-resistant material layer, for example, the thickness of the corrosion-resistant material layer is 0.2 to 1.5 mm, which may be set by those skilled in the art according to the actual situation.

As shown in FIGS. 1 and 2, in an embodiment, the first heat pipe 3 and the second heat pipe 4 are both U-shaped pipes, and the two U-shaped pipes are arranged on the heat dissipation aluminum substrate 1 in the form of two ends protruding opposite each other. That is, a first port 31 of the first heat pipe 3 and a second port 41 of the second heat pipe 4 are adjacent to each other, and the first port 31 and the second port 41 are disposed in opposite directions; and a third port 32 of the first heat pipe 3 and a fourth port 42 of the second heat pipe 4 are far away from each other, and the third port 32 and the fourth port 42 are disposed in opposite directions. In this way, the first heat pipe 3 and the second heat pipe 4 have the same efficiency, so that the heat dissipation aluminum block 2 is subjected to a uniform contact force and does not warp on one side, and the heat dissipation aluminum block 2 remains horizontal.

In this embodiment, the first heat pipe 3 and the second heat pipe 4 have the same structural dimension, the first port 31 of the first heat pipe 3 and the fourth port 42 of the second heat pipe 4 are out of the same vertical plane, and the third port 32 of the first heat pipe 3 and the second port 41 of the second heat pipe 4 are out of the same vertical plane. Such a configuration is adapted to the overall structure of the heat dissipation aluminum block 2 and the heat dissipation aluminum substrate 1, without affecting the efficiency of the first heat pipe 3 and the second heat pipe 4.

It should be noted that the invention does not impose specific limitations on the material of the first heat pipe 3 and the second heat pipe 4, for example, the first heat pipe 3 and the second heat pipe 4 are both made of copper, which may be set by those skilled in the art according to the actual situation.

As shown in FIG. 2, in an embodiment, a third recess 21 is formed in the bottom of the heat dissipation aluminum block 2 and configured for embedding the ends of the first heat pipe 3 and the second heat pipe 4 that abut against each other. The third recess 21 is provided to avoid displacement of the first heat pipe 3 and the second heat pipe 4 such that the first heat pipe 3 and the second heat pipe 4 are confined under the heat dissipation aluminum block 2, thereby saving space.

In this embodiment, the overall width of a front portion 33 of the first heat pipe 3 and a front portion 43 of the second heat pipe 4 after they are attached to each other matches the width of the third recess 21 such that the front portion 33 of the first heat pipe 3 and the front portion 43 of the second heat pipe 4 abut in the third recess 21 to avoid shaking. The length of the third recess 21 is slightly smaller than the length of the front portion 33 of the first heat pipe 3 and the length of the front portion 43 of the second heat pipe 4 such that the first port 31 of the first heat pipe 3 and the second port 41 of the second heat pipe 4 may be exposed to the outside of the third recess 21. Moreover, since the first port 31 of the first heat pipe 3 and the second port 41 of the second heat pipe 4 are in opposite directions, the efficiency of the first heat pipe 3 and the second heat pipe 4 is not affected, and the contact forces generated by the first heat pipe 3 and the second heat pipe 4 are complementary, which accordingly has less impact on the heat dissipation aluminum block 2 and helps the heat dissipation aluminum block 2 remain steady.

Specifically, the upper surface of the first heat pipe 3 and the upper surface of the second heat pipe 4 as well as the lower surface of the first heat pipe 3 and the lower surface of the second heat pipe 4 are all flat surfaces; the inner side surface of the first heat pipe 3 and the inner side surface of the second heat pipe 4 as well as the outer side surface of the first heat pipe 3 and the outer side surface of the second heat pipe 4 are also flat surfaces; and the third recess 21 is a rectangular recess. The upper surface of the third recess 21 abuts on the upper surface of the first heat pipe 3 and the upper surface of the second heat pipe 4, one side surface of the third recess 21 abuts on the outer side surface of the front portion 33 of the first heat pipe 3, the other side surface of the third recess 21 abuts on the outer side surface of the front portion 43 of the second heat pipe 4, and the inner side surface of the front portion 33 of the first heat pipe 3 abuts on the inner side surface of the front portion 43 of the second heat pipe 4. In this way, the front portion 33 of the first heat pipe 3 and the front portion 43 of the second heat pipe 4 abut against the inner side of the third recess 21, solving the problem of the short circuit of the circuit board due to the impact on the heat dissipation aluminum block 2 in the case of the first heat pipe 3 and the second heat pipe 4 shaking and vibrating.

Optionally, the front ends of both the first heat pipe 3 and the second heat pipe 4 may protrude from an end portion of the third recess 21, or may be flush with the end portion of the third recess 21, and this may be set by those skilled in the art according to the actual situation on the premise of not affecting the efficiency of the first heat pipe 3 and the second heat pipe 4.

As shown in FIGS. 2 and 3, in an embodiment, a hollow structure 11 is formed in the middle of the heat dissipation aluminum substrate 1, the end of the first heat pipe 3 and the end of the second heat pipe 4 that abut against each other are both located in the hollow structure 11, and the heat dissipation aluminum block 2 is secured to the hollow structure 11 by welding. The hollow structure 11 is provided for mounting the heat dissipation aluminum block 2, the first heat pipe 3 and the second heat pipe 4 to enable the structure complete and rational.

It should be noted that the invention does not impose specific limitations on the dimensions of the hollow structure 11 as long as it is ensured that the heat dissipation aluminum block 2, the first heat pipe 3 and the second heat pipe 4 are mounted inside the hollow structure 11 and the hollow structure has no gap with the heat dissipation aluminum block 2, and those skilled in the art may set the dimensions according to the actual situation.

As shown in FIGS. 2 and 3, in an embodiment, lugs 23 are symmetrically arranged at two sides of the bottom of the heat dissipation aluminum block 2, first mounting grooves 12 are symmetrically provided at two sides of the hollow structure 11, and the lugs 23 abut in the first mounting grooves 12 respectively such that the heat dissipation aluminum block 2 is positioned. With the lugs 23 and the first mounting grooves 12, the heat dissipation aluminum block 2 is confined to the interior of the hollow structure 11, and the heat dissipation aluminum block 2 is embedded in the hollow structure 11, thus avoiding the shaking caused by an external force.

Optionally, the lugs 23 are rectangular, and the first mounting grooves 12 are also rectangular, so that the lugs 23 and the first mounting grooves 12 may match with each other well to achieve the restriction. Of course, the lugs 23 and the first mounting grooves 12 are not limited to be rectangular, but may also be circular, and their specific shapes may be set by those skilled in the art according to the actual situation.

As shown in FIGS. 2 and 3, in an embodiment, the hollow structure 11 comprises a first opening 13 and a second opening 14 that are symmetrically provided. The first opening 13 is configured for the insertion of the second heat pipe 4 and turns on one side of the upper portion of the heat dissipation aluminum substrate 1, the second opening 14 is configured for the insertion of the first heat pipe 3 and turns on the other side of the upper portion of the heat dissipation aluminum substrate 1, and the second heat pipe 3 and the first heat pipe 4 turn in opposite directions such that the first heat pipe 3 and the second heat pipe 4 are in the form of two ends protruding opposite each other. The first opening 13 and the second opening 14 provide space for the first heat pipe 3 and the second heat pipe 4 such that the form of two ends protruding opposite each other is realized, making the structure rational.

Specifically, a middle portion 44 of the second heat pipe 4 is arranged in the first opening 13, and a rear portion 45 of the second heat pipe 4 extends in the second recess 16. A middle portion 34 of the first heat pipe 3 is arranged in the second opening 14, and a rear portion 35 of the first heat pipe 3 extends in the first recess 15. In this way, a turning space for the first heat pipe 3 and the second heat pipe 4 is provided, so that the form of two ends protruding opposite each other is realized, and the contact forces of the first heat pipe 3, the second heat pipe 4, and the heat dissipation aluminum block 2 are equal to make the heat dissipation aluminum block 2 remain steady.

It should be noted that the invention does not impose specific limitations on the dimensions of the first opening 13 and the second opening 14, which may be set by those skilled in the art according to the actual situation.

As shown in FIGS. 2 and 3, in an embodiment, a first recess 15 and a second recess 16 are symmetrically formed in the upper portion of the heat dissipation aluminum substrate 1. The first recess 15 is configured for the embedding of the first heat pipe 3 and the second recess 16 is configured for the embedding of the second heat pipe 4; the first recess 15 and the second opening 14 are connected in a through manner, and the second recess 16 and the first opening 13 are connected in a through manner, so that the end of the first heat pipe 3 and the end of the second heat pipe 4 that abut against each other are both located in the hollow structure 11. The first recess 15 and the second recess 16 are provided for hiding the corresponding first heat pipe 3 and second heat pipe 4 therein, so that the space is saved, the efficiency of the first heat pipe 3 and the second heat pipe 4 is also not affected, and the first heat pipe and the second heat pipe will not be pressed or rubbed with other devices during mounting, thus achieving a protection function.

In this embodiment, the first recess 15 and the second recess 16 are both rectangular, which match the shapes of the first heat pipe 3 and the second heat pipe 4, thus the first heat pipe 3 and the second heat pipe 4 will not be loosened.

As shown in FIGS. 2 and 3, in an embodiment, the controller further comprises a plurality of elastic members 5. The plurality of elastic members 5 are mounted at equal intervals under the heat dissipation aluminum block 2 such that the heat dissipation aluminum block 2 is in a horizontal state.

### Preferably, the elastic members 5 are springs.

Specifically, a plurality of second mounting grooves 22 are symmetrically formed in the bottom of the heat dissipation aluminum block 2, the plurality of second mounting grooves 22 are provided in one-to-one correspondence with the plurality of elastic members 5, and upper ends of the elastic members 5 are inserted in the second mounting grooves 22, respectively. In this way, the heat dissipation aluminum block 2 is kept horizontal to some extent, so that there is no gap when it is in contact with a chip, and the contact thermal resistance is reduced. Moreover, since the first heat pipe 3 and the second heat pipe 4 are symmetrical structures, the contact force with the chip will be more uniform, avoiding stress concentration that may lead to the failure of the chip.

A second aspect of the invention provides a vehicle, which comprises an in-vehicle heat-pipe heat dissipation controller as described above.

The vehicle of the technical solution comprises an in-vehicle heat-pipe heat dissipation controller as in any technical solution of the invention, and thus the vehicle has all the technical effects of the in-vehicle heat-pipe heat dissipation controller as in any technical solution of the invention.

It should be noted that, unless otherwise specified, the technical terms or scientific terms used in the invention shall have common meanings understood by persons skilled in the art to which the invention relates.

In the description of the invention, it should be understood that the orientation or position relationship indicated by the terms "central", "longitudinal", "transverse", "length", "width", "thickness", "upper", "lower", "front"; "rear", "left", "right", "vertical", "horizontal", "top", "bottom", "inner", "outer", "clockwise", "counterclockwise", "axial", "radial", "circumferential", etc. are based on the orientation or position relationship as shown in the accompanying drawings and are merely intended to facilitate and simplify the description of the invention, rather than indicating or implying that the device or element considered must have a particular orientation or be constructed and operated in a particular orientation, and therefore not to be construed as limiting the invention.

In addition, the terms "first", "second", etc. are merely for the purpose of description, and shall not be understood as any indication or implication of relative importance or any implicit indication of the number of technical features indicated. In the description of the invention, the term "a plurality of" means two or more, unless otherwise explicitly and specifically defined.

In the description of the invention, unless otherwise explicitly specified and defined, the terms such as "mount", "couple", "connect", and "fix" should be understood in a broad sense, for example, they may be a fixed connection, a detachable connection, or an integrated connection; may be a mechanical connection or an electrical connection; or may be a direct connection or an indirect connection by means of an intermediate medium, or may be communication between interiors of two elements or interaction between the two elements. For those of ordinary skill in the art, the specific meanings of the above terms in the invention can be understood according to specific situations.

In the invention, unless otherwise explicitly specified and defined, the first feature being "above" or "below" the second feature may refer to the first feature being in direct contact with the second feature, or the first feature being brought into indirect contact with the second feature via an intermediate medium. Moreover, the expression of the first feature being "over", "above" and "on top of" the second feature may be the case that the first feature is directly above or obliquely above the second feature, or only means that the level of the first feature is higher than the second feature. The expression of the first feature being "underneath", "below" and "beneath" the second feature may be the case that the first feature is directly below or obliquely below the second feature, or only means that the level of the first feature is lower than the second feature.

Heretofore, the technical solutions of the invention have been described with reference to the preferred implementations shown in the accompanying drawings. However, those skilled in the art can readily understand that the scope of protection of the invention is apparently not limited to these specific implementations. Without departing from the principles of the invention, those skilled in the art may make equivalent changes or replacements to related technical features. The technical solutions obtained after these changes or replacements fall within the scope of protection of the invention.

## Claims

1. An in-vehicle heat-pipe heat dissipation controller, **characterized in that** the controller comprises a heat dissipation aluminum substrate, a heat dissipation aluminum block, a first heat pipe and a second heat pipe;
wherein the first heat pipe and the second heat pipe are arranged on the heat dissipation aluminum substrate, and the heat dissipation aluminum block is secured onto the heat dissipation aluminum substrate and arranged above one end of the first heat pipe as well as one end of the second heat pipe; and
the surface of the heat dissipation aluminum substrate, the surface of the heat dissipation aluminum block, the surface of the first heat pipe and the surface of the second heat pipe are each plated with a corrosion-resistant material layer for oxidation resistance.

2. The in-vehicle heat-pipe heat dissipation controller according to claim 1, **characterized in that** the corrosion-resistant material layer is made of nickel aminosulfonate.

3. The in-vehicle heat-pipe heat dissipation controller according to claim 1 or 2, **characterized in that** the first heat pipe and the second heat pipe are both U-shaped pipes, the two U-shaped pipes are arranged on the heat dissipation aluminum substrate in the form of two ends protruding opposite each other, and the ends of the two U-shaped pipes under the heat dissipation aluminum block abut against each other.

4. The in-vehicle heat-pipe heat dissipation controller according to claim 3, **characterized in that** a third recess is formed in the bottom of the heat dissipation aluminum block and configured for embedding the ends of the first heat pipe and the second heat pipe that abut against each other.

5. The in-vehicle heat-pipe heat dissipation controller according to claim 3, **characterized in that** a hollow structure is formed in the middle of the heat dissipation aluminum substrate, the end of the first heat pipe and the end of the second heat pipe that abut against each other are both located in the hollow structure, and the heat dissipation aluminum block is secured to the hollow structure.

6. The in-vehicle heat-pipe heat dissipation controller according to claim 3, **characterized in that** lugs are symmetrically arranged at two sides of the bottom of the heat dissipation aluminum block, first mounting grooves are symmetrically provided on two sides of the hollow structure, and the lugs abut in the first mounting grooves respectively such that the heat dissipation aluminum block is restricted.

7. The in-vehicle heat-pipe heat dissipation controller according to claim 5, **characterized in that** the hollow structure comprises a first opening and a second opening that are symmetrically provided; and
the first opening is configured for the insertion of the second heat pipe and turns on one side of the upper portion of the heat dissipation aluminum substrate, the second opening is configured for the insertion of the first heat pipe and turns on the other side of the upper portion of the heat dissipation aluminum substrate, and the second heat pipe and the first heat pipe turn in opposite directions such that the first heat pipe and the second heat pipe are in the form of two ends protruding opposite each other.

8. The in-vehicle heat-pipe heat dissipation controller according to claim 7, **characterized in that** a first recess and a second recess are symmetrically formed in the upper portion of the heat dissipation aluminum substrate;
the first recess is configured for the embedding of the first heat pipe; and
the second recess is configured for the embedding of the second heat pipe;
wherein the first recess and the second opening are connected in a through manner, and the second recess and the first opening are connected in a through manner, so that the end of the first heat pipe and the end of the second heat pipe that abut against each other are both located in the hollow structure.

9. The in-vehicle heat-pipe heat dissipation controller according to any one of claims 1 to 8, **characterized in that** the controller further comprises a plurality of elastic members, and the plurality of elastic members are mounted at equal intervals under the heat dissipation aluminum block such that the heat dissipation aluminum block is in a horizontal state;
wherein a plurality of second mounting grooves are symmetrically formed in the bottom of the heat dissipation aluminum block, the plurality of second mounting grooves are provided in one-to-one correspondence with the plurality of elastic members, and upper ends of the elastic members are inserted in the second mounting grooves, respectively.

10. A vehicle, comprising an in-vehicle heat-pipe heat dissipation controller according to any one of claims 1 to 9.
